# EUROPEAN PATENT APPLICATION

(11) **EP 4 664 139 A1**
(43) Date of publication of application: **17.12.2025**
(21) Application number: 25181351.5
(22) Date of filing: 06.06.2025
(51) Int. Cl.: G01R 33/54, G01R 33/565, G01R 33/483, G01R 33/56

(54) **MAGNETIC RESONANCE IMAGING WITH BODY MOVEMENT CORRECTION**

(30) Priority: 11.06.2024 JP 2024094516
(71) Applicant: FUJIFILM Corporation, Tokyo Tokyo 106-8620 (JP)
(72) Inventor: HOSHINO, Yusuke, Tokyo (JP)
(74) Representative: Dehns Germany Partnerschaft mbB

(57) **Abstract**

Provided is a technology for displaying information about automatically performed correction in a form in which a user can check the information while improving usability of body movement correction.

In a case where an image subjected to body movement correction (body movement-corrected image) is displayed, a reference image for the image is also displayed. Alternatively, information regarding the body movement correction such as information indicating that the body movement-corrected image is the image subjected to the body movement correction, and a condition for the body movement correction, is also displayed. The reference image displayed together with the body movement-corrected image is, for example, any one or more images of an image (original image) reconstructed using the same measurement data without performing the body movement correction, an image (image without body movement correction) that has a different slice position or cross-sectional position captured consecutively to imaging of the body movement-corrected image, that does not require the body movement correction, and that is not subjected to the body movement correction, or difference image between the original image and the body movement-corrected image.

## Description

### CROSS-REFERENCE TO RELATED APPLICATIONS

The present application claims priority under 35 U.S.C. § 119 to Japanese Patent Application No. 2024-094516, filed June 11, 2024. Each of the above application(s) is hereby expressly incorporated by reference, in its entirety, into the present application.

### BACKGROUND OF THE INVENTION

### 1. Field of the Invention

The present invention relates to a magnetic resonance imaging apparatus (hereinafter, referred to as an MRI apparatus), and particularly to a display technology for an image acquired by the MRI apparatus.

### 2. Description of the Related Art

An MRI apparatus reconstructs a nuclear magnetic resonance signal collected from a subject and produces an image. The image can be reconstructed immediately after the nuclear magnetic resonance signal required for the reconstruction is collected, and the image is displayed in parallel with an examination or immediately after the examination. However, in an examination in which it is necessary to perform post-correction processing on the reconstructed image, user settings for the correction processing may be required. As a typical example, there is a case where body movement information is acquired by analyzing a movement of a subject acquired in parallel with an examination, and the body movement information is used to correct a reconstructed image, or to reconstruct an image in which a body movement is corrected during image reconstruction. In such a body movement correction technology, in order to appropriately perform body movement correction, image reconstruction is performed after a user selects whether or not to perform correction, selects an image reconstruction method, and sets conditions such as correction intensity. Therefore, there is a problem of poor usability.

Contrary to this, a technology has been proposed that automatically discriminates the degree and type of body movement information without requiring the user setting after imaging and determines image reconstruction processing (JP2023-022669A). By using such a technology, the burden on the user is significantly reduced, but it is difficult to confirm whether or not the image reconstructed by performing the body movement correction is an appropriately corrected image. JP2023-022669A also proposes displaying an original image before body movement correction simultaneously with an image that has been subjected to the body movement correction. Through the comparison with the original image, it is possible to confirm that image quality has been improved by the body movement correction, but it is not possible to grasp whether or not the body movement correction that has been performed is appropriate.

In addition, JP2015-198958A discloses, as an example of displaying an image in a case where body movement correction is performed, that when a subject has moved while a plurality of protocols (imaging) are performed, an image of the protocol in which the movement occurred and an automatically corrected image are displayed, and a mark indicating that the movement occurred and that automatic correction was performed is attached.

### SUMMARY OF THE INVENTION

As described above, in the technology described in JP2023-022669A, usability is improved, but it is not possible to grasp whether or not the automatically performed body movement correction is appropriate.

In the technology described in JP2015-198958A, the user can check the image subjected to the body movement correction through the image that has been captured in a case where the body movement occurs among the images of the plurality of protocols and that has been displayed in a distinguishable manner, but it is not possible to grasp whether or not the body movement correction is appropriate unlike JP2023-022669A.

In addition, in a case of multi-slice imaging, body movement correction is applied to measurement data collected when a body movement occurs. Therefore, there may be cases where a plurality of slice images obtained by the multi-slice imaging include a mixture of images subjected to the body movement correction and images not subjected to the body movement correction. However, in the related art, it is not possible to obtain information such as which slice has been subjected to the body movement correction and which slice does not require the body movement correction.

An object of the present invention is to provide a technology for displaying information about automatically performed correction in a form in which a user can check the information while improving usability of body movement correction.

In order to solve the above problems, in an embodiment of the present invention, in a case where an image subjected to body movement correction (body movement-corrected image) is displayed, a reference image for the image is also displayed. Alternatively, information regarding the body movement correction such as information indicating that the body movement-corrected image is the image subjected to the body movement correction, and a condition for the body movement correction, is also displayed. The image subjected to the body movement correction includes at least one of an image corrected by body movement correction reconstruction or an image in which the body movement is corrected by re-measurement. In addition, the reference image displayed together with the body movement-corrected image is, for example, any one or more images of an image (original image) reconstructed using the same measurement data without performing the body movement correction, an image (image without body movement correction) that has a different slice position or cross-sectional position captured consecutively to imaging of the body movement-corrected image, that does not require the body movement correction, and that is not subjected to the body movement correction, or difference image between the original image and the body movement-corrected image.

That is, an MRI apparatus according to an embodiment of the present invention comprises: an imaging unit that collects a nuclear magnetic resonance signal of a subject; an image generation unit that reconstructs an image of the subject using k-space data consisting of the nuclear magnetic resonance signal collected by the imaging unit; a body movement processing unit that analyzes a body movement of the subject during imaging; and a display control unit that displays the image generated by the image generation unit on a display device. The image generation unit performs body movement correction based on an analysis result of the body movement processing unit to generate an image subjected to the body movement correction. The display control unit displays, in a case of displaying the image subjected to the body movement correction generated by the image generation unit, at least one of a reference image related to the image subjected to the body movement correction or information regarding the body movement correction on the display device.

In addition, a method for displaying an image according to an aspect of the present invention is a method for displaying an image acquired by an MRI apparatus on a display device, in which the image includes an image subjected to correction of a body movement of a subject that has occurred during imaging, the method comprising: displaying at least one of a reference image related to the image subjected to the body movement correction or information regarding the body movement correction.

The method for displaying an image according to the aspect of the present invention is implemented by a processor associated with the MRI apparatus or independent of the MRI apparatus.

In the present specification, the terms "imaging" and "measurement" are synonymous with the terms generally used in the MRI field and should not be interpreted in a limited manner. Unless otherwise specified, "imaging" means individual imaging constituting various types of imaging included in an MRI examination protocol, and "measurement" means measurement of a nuclear magnetic resonance signal in imaging.

According to the embodiment of the present invention, even in a case where the determination of whether or not to perform the body movement correction and the determination of the condition for performing the body movement correction are automated in a system, the information can be conveyed to a user. In addition, even in a case where a plurality of images having different slice positions are acquired and displayed at the same time as in the case of multi-slice imaging, the user can check the image subjected to the body movement correction among the plurality of images, and can also check whether or not the body movement correction is appropriate.

### BRIEF DESCRIPTION OF THE DRAWINGS

Fig. 1 is a diagram showing an overall configuration of an MRI apparatus to which an embodiment of the present invention is applied.
Fig. 2 is a diagram showing an embodiment of a flow of an operation of the MRI apparatus.
Fig. 3 is a diagram showing an example of a multi-slice pulse sequence.
Fig. 4 is a diagram showing a display example of a slice image of Embodiment 1.
Fig. 5 is a diagram showing a modification example of the display.
Fig. 6 is a diagram showing another modification example of the display.
Fig. 7 is a diagram showing a display example of Embodiment 2.
Fig. 8 is a diagram showing another display example of Embodiment 2.
Fig. 9A is a diagram showing still another display example of Embodiment 2.
Fig. 9B is a diagram showing still another display example of the embodiment 2.
Fig. 10 is a diagram showing a flow of an operation of Embodiment 3.
Fig. 11 is a diagram showing measurement data of Embodiment 3.
Fig. 12 is a diagram showing a display example of Embodiment 3.

### DESCRIPTION OF THE PREFERRED EMBODIMENTS

Hereinafter, embodiments of the invention will be described.

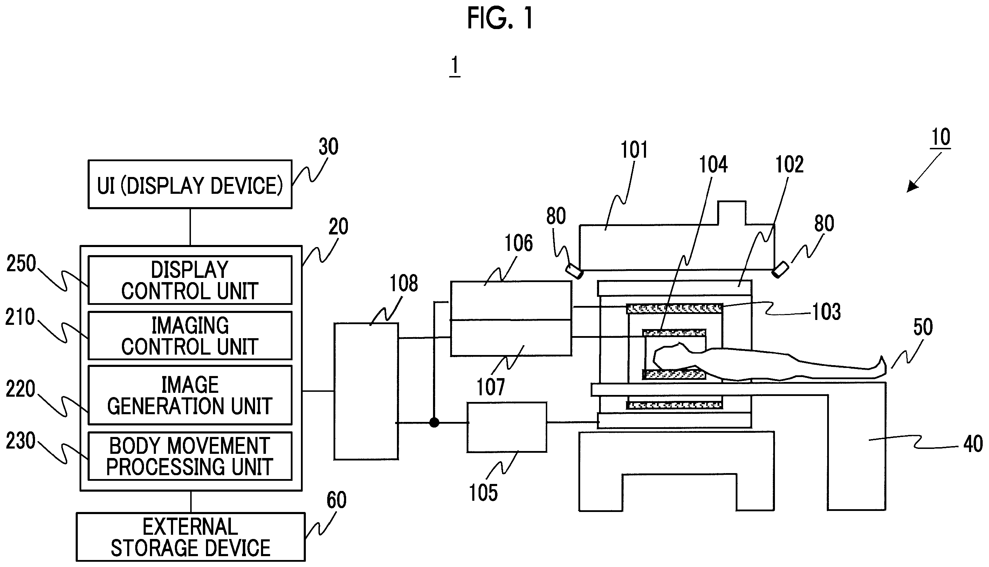

First, an overview of an MRI apparatus will be described with reference to Fig. 1.

As shown in Fig. 1, the MRI apparatus is roughly divided into an imaging unit 10, a processor 20 that performs various controls and calculations, and a user interface (UI) unit 30 that allows communication between the imaging unit 10 and the processor 20 and a user. Main elements constituting the imaging unit 10 are housed in a gantry that provides an examination space.

The imaging unit 10 induces nuclear magnetic resonance in nuclei (usually protons) of atoms that constitute a tissue of a subject, and collects nuclear magnetic resonance signals (NMR signals) generated thereby from the subject. Hereinafter, the nuclear magnetic resonance signal is also simply referred to as a signal or an echo signal.

A configuration of the imaging unit 10 is similar to that of a known MRI apparatus, and comprises a static magnetic field magnet 101 that generates a uniform magnetic field (static magnetic field) in the examination space in which a subject 50 is placed, a gradient magnetic field coil 102 that applies a gradient magnetic field to the static magnetic field, an RF transmission coil 103 that applies a high-frequency magnetic field to excite the nuclei of the atoms constituting the tissue of the subject, and an RF reception coil 104 that receives an NMR signal generated by the subject, in which the gradient magnetic field coil 102, the RF transmission coil 103, and the RF reception coil 104 are connected to a gradient magnetic field power supply 105, a transmitter 106, and a receiver 107, respectively. Operations of the gradient magnetic field power supply 105, the transmitter 106, and the receiver 107 are controlled by a sequencer 108. The sequencer 108 determines a pulse sequence for each scan using a set pulse sequence type and imaging conditions such as imaging parameters, and controls each component of the imaging unit 10 to operate in accordance with the determined pulse sequence and collect an echo signal (k-space data) necessary for image reconstruction. Since functions and operations of each component in a case where the imaging unit 10 collects the k-space data are similar to those of a general MRI apparatus, detailed description thereof will be omitted here.

The static magnetic field magnet 101, the gradient magnetic field coil 102, and the RF transmission coil 103 are housed in the gantry, and the subject 50 is positioned in the examination space in the gantry in a state of being laid on a bed device 40 with the RF reception coil 104 attached to an examination area.

The processor 20 has a function as a control unit that controls imaging via the sequencer 108 and that controls operations of the entire apparatus, and a function as a calculation unit that reconstructs an image of the subject using the echo signal collected by the imaging unit 10 or performs a calculation such as correction on the k-space data before reconstruction or an image after reconstruction.

The processor 20 of the present embodiment has a function of collecting and processing body movement information generated in the subject 50 during an examination, for example, a magnitude and duration of a body movement, and associating the body movement information with a scan in progress (imaging) to be presented to a user, in addition to the functions of the control unit and the calculation unit described above.

The processor 20 includes processing units such as an imaging control unit 210, an image generation unit 220, a body movement processing unit 230, and a display control unit 250. The processing units may be configured so that all functions are implemented by one processor, but each unit may be configured by a separate processor, either alone or in combination. In the present specification and Fig. 1, the processor 20 is referred to as a representative. The processor or the processing unit can be configured as a known computing device such as a computer comprising a CPU and a memory, a programmable IC, or a combination thereof, and in a case of a computer, functions are implemented by the CPU reading a program for achieving the functions.

The UI unit 30 is a device that provides the user with a unit for performing interactive communication with an MRI apparatus 1. The UI unit 30 comprises a display device, an input device, and the like as the unit for performing communication with the user, and these are connected to the processor 20 and mainly operate under the control of the display control unit 250. For example, the display control unit 250 and the UI unit 30 perform processing of displaying an image generated by the image generation unit 220 or the associated information on the display device in a predetermined display form, displaying a GUI for the user to input various conditions or settings related to the operation of the MRI apparatus 1, such as imaging, image generation (including correction), and display, on the display device, receiving user settings, and passing the user settings to the related functional unit.

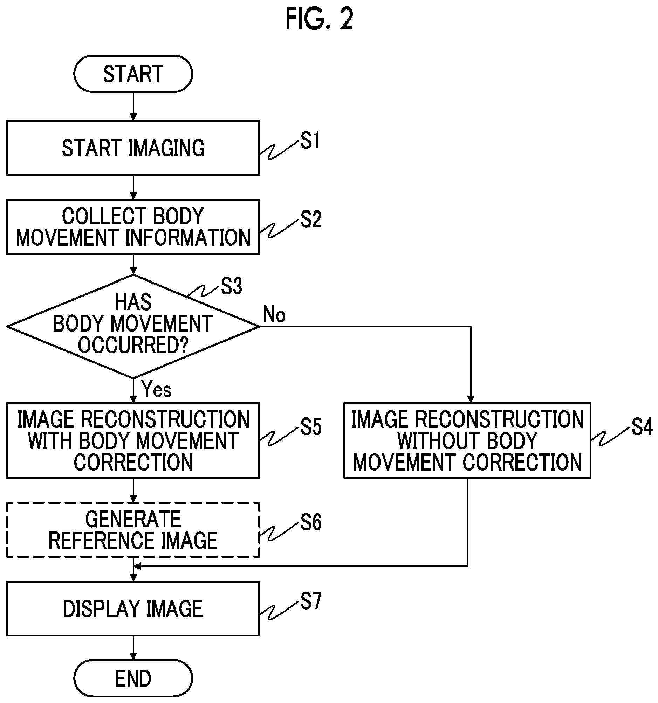

Next, a flow of an imaging operation of the MRI apparatus 1 in the above configuration will be described with reference to Fig. 2.

The subject 50 is placed in the examination space, and the imaging is started (S1). Imaging is an operation performed by the imaging unit 10 to acquire an image necessary for an examination area of a subject, and means imaging in a broad sense including imaging of one cross section (one slice or one slab) or imaging of a plurality of cross sections, and pre-scanning. Specific conditions for imaging, that is, a pulse sequence and scan parameters (the number of slices, FOV, TE, TR, R factor, and the like) used for imaging are not particularly limited, and imaging is performed by setting various known conditions using known setting methods.

Before or simultaneously with the start of imaging, a movement of the subject is monitored, and body movement information is collected (S2). The movement of the subject can be acquired, for example, by collecting a navigator echo for monitoring the movement of the subject separately from the echo signal for image reconstruction, and analyzing a change in a profile obtained by performing Fourier transform on the navigator echo in a direction of the movement to be monitored or a change in the navigator echo itself. Since various sequences are known as a pulse sequence for collecting a navigator echo and an imaging sequence accompanying the pulse sequence, a description of specific sequences will be omitted here.

In addition, it is also possible to obtain the movement from a video from one or a plurality of surveillance cameras 80 installed in the gantry of the MRI apparatus 1 or in the vicinity of the gantry or a signal from a biological signal monitor worn by the subject, instead of the navigator echo. The body movement processing unit 230 analyzes the video or the signal and collects body movement information such as a magnitude of the body movement, information regarding a body movement occurrence time, and a type of the body movement. For the acquisition of the movement information using the video of the surveillance camera, for example, a known method such as an optical flow calculation between frame images can be adopted. In addition, in a case where a respiratory movement, heart rate, or the like is obtained as a biological signal, it is also possible to discriminate the presence or absence of body movement that affects the image by using the signal.

As a result of the analysis by the body movement processing unit 230, while body movements affecting the image, such as sudden movements excluding relatively small periodic movements such as respiratory movements and pulsation, and positional deviations are not detected, the image generation unit 220 reconstructs the image using a known image reconstruction method such as the Fourier transform or the PI calculation as long as measurement data (k-space data) necessary for reconstructing the image is collected (S4).

As a result of the analysis by the body movement processing unit 230, in a case where it is determined that there is a body movement that affects the image during the collection of the k-space data for reconstructing one image (S3), the image generation unit 220 performs body movement correction and performs image reconstruction (S5). For an image reconstruction method with the body movement correction, a known method such as the method described in JP2023-022669A can be adopted. For example, image reconstruction is performed by sequential calculation reconstruction excluding measurement data that affects the image from the k-space data, and the body movement correction is performed. In this case, a limit may be set for the number of pieces of the measurement data to be subjected to the sequential calculation reconstruction, or a limit may be set for a region of the k-space (low-frequency or high-frequency). In addition, depending on the number of pieces and region of the measurement data (also called correction target data) measured when the body movement occurs, it is also possible to adopt other body movement correction reconstructions, such as replacing measurement data affected by the body movement with zero (zero-filling) and performing image reconstruction, or performing image reconstruction through half-scan estimation or data estimation using the Hermitian symmetry of k-space.

It should be noted that the conditions for performing the body movement correction, the intensity of the correction, the reconstruction method, and other conditions may be set by the user through the UI unit 30, or the body movement processing unit 230 may discriminate the body movement as described in JP2023-022669A, automatically set the conditions according to the discrimination result, and perform the body movement correction. From the viewpoint of usability, the latter is advantageous, and in a case where the latter is adopted, the effectiveness of the present embodiment related to the improvement of the display method is enhanced.

In a case where an image is generated by the image generation unit 220, the display control unit 250 displays the image on the display device of the UI unit 30 (S7). In the MRI apparatus 1 according to the present embodiment, in a case where an image (body movement-corrected image) that has been subjected to body movement correction is included in the image to be displayed on the display device, at least one of a reference image related to the image or information regarding the body movement correction is displayed together. Examples of the reference image include an image (original image) reconstructed without the body movement correction using the same measurement data as the body movement-corrected image, an image (image without body movement correction) that is acquired sequentially with the body movement-corrected image but has a different slice position or cross-sectional position and that does not require body movement correction and is not subjected to the body movement correction, and a difference image between the original image and the body movement-corrected image. The reference image to be displayed may be set as a default in advance, or may be selected by the user and displayed. In a case where the reference image to be displayed is not generated, the image generation unit 220 generates the above-described reference image (S6).

The information regarding the body movement correction includes the position or the number of pieces (a ratio to the k-space) of the measurement data deleted as having an effect on the image in the k-space, the intensity of the body movement correction, the body movement correction reconstruction method, and the like.

The display control unit 250 displays, on the display device, at least one of the above-described reference image or the information regarding the body movement correction, together with the body movement-corrected image. A specific display method will be described in detail in the following embodiment.

According to the present embodiment, it is possible to provide the user with information for determining whether or not the body movement correction is appropriate, together with the body movement-corrected image. As a result, the user can determine the reliability of a diagnosis using the body movement-corrected image or can perform more appropriate body movement correction again.

Hereinafter, a specific example of the display will be described. In the following embodiments, the drawings used in the above description will be referred to again for embodiments that share the configuration and processing of the above-mentioned MRI apparatus.

### Embodiment 1

The present embodiment relates to a display method in a case where a body movement occurs while a plurality of cross-sectional images (slice images) are captured, and body movement correction reconstruction is performed on some of the plurality of slice images.

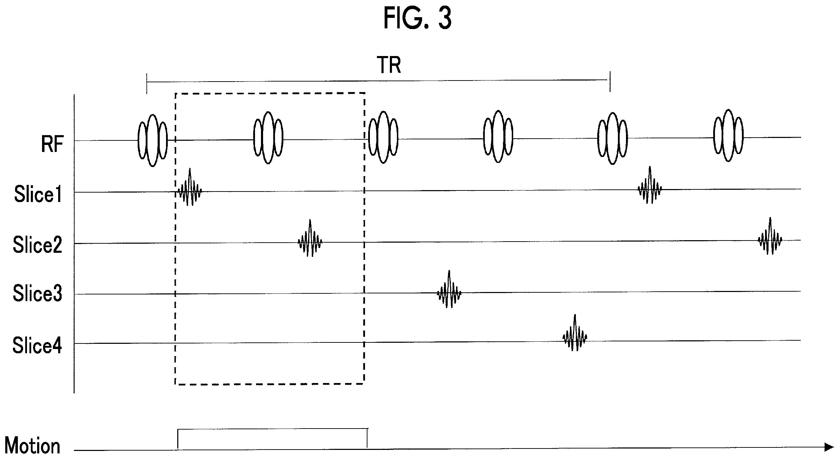

In multi-slice imaging of MRI, a three-dimensional region, which is an examination area, is divided into a plurality of slices, and k-space data consisting of a nuclear magnetic resonance signal (echo signal) is acquired for each slice to obtain an image for each slice. In a pulse sequence of the multi-slice imaging, for example, as shown in Fig. 3, excitation and signal measurement of one slice are performed within a repetition time TR of another slice, and this is repeated in order to acquire k-space data for each slice. In Fig. 3, for simplicity of description, gradient magnetic field pulses other than RF pulses for excitation and echo signals are omitted, and a case of four slices is shown. In addition, although not shown in Fig. 3, in a case where body movement information is acquired from navigator echoes, the generation and collection of the navigator echoes are added.

In a case where a body movement occurs during the multi-slice imaging, measurement data that is not affected by the body movement and measurement data that is affected by the body movement and is a target of the body movement correction are mixed. For example, in the example shown in Fig. 3, the body movement occurs during the measurement of Slice1 and Slice2, and these slices are affected by the body movement, but the body movement does not occur during the measurement of Slice3 and Slice4.

The image generation unit 220 determines the presence or absence of measurement data affected by the body movement for each slice, a ratio to the k-space data, a ratio included in a low-frequency region of the k-space, and the like based on the body movement information analyzed by the body movement processing unit 230, and generates a slice image. The ratio to the k-space data means a ratio of data of a line where the body movement has occurred to the number of pieces of data in a ky direction of the k-space (ky-kx space), and in a case where the body movement correction is performed by sequential calculation reconstruction or the like by deleting the data, a SN of a reconstructed image is affected by the ratio. In addition, image reconstruction may not be possible depending on the ratio. The ratio included in the low-frequency region of the k-space is, in a case where data is present in the low-frequency region of the k-space among the data of the line where the body movement has occurred, a ratio of the data to low-frequency data of the k-space (for example, data occupying 30% of the k-space centered on zero encoding of the k-space), and the image quality is significantly deteriorated as the ratio is increased. Therefore, in a case where the body movement correction is performed, for example, a predetermined threshold is set for these ratios, and the body movement correction is performed. In a case where the threshold is exceeded, re-measurement is performed without performing the body movement correction.

As described above, as a result of generating the image by determining whether or not the body movement correction is necessary for each slice, the generated slice images include a mixture of slice images generated by performing the body movement correction and slice images that have not been subjected to the body movement correction.

In the present embodiment, in a case where the image of each slice generated by the image generation unit 220 is displayed on the display device, the display control unit 250 displays, together with the image of each slice, the slice image that has been subjected to the body movement correction in a distinguishable manner from the slice image that has not been subjected to the body movement correction (a reference image for the slice image that has been subjected to the body movement correction). The display of "distinguishable" is not particularly limited as long as the display is in a form that allows the user to recognize that the image that has been subjected to the body movement correction is an image that has been subjected to processing different from the reference image. For example, a display in which one or a combination of the following: making the background of the image different, making the thickness or color of the frame of the image different, or adding a mark indicating that the body movement correction has been performed to the margin of the image is performed. It is also possible to display the content of the body movement correction itself.

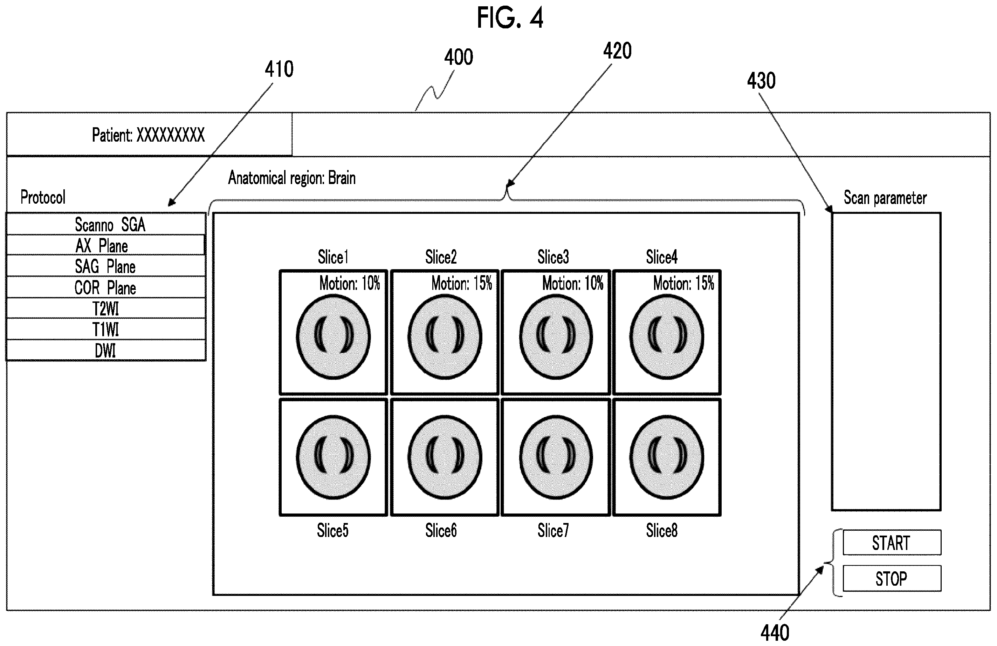

Fig. 4 shows an example of the display. A display screen 400 shown in the figure consists of blocks such as a protocol display block 410 that displays a series of imaging processes (protocol) performed in the MRI examination, a scan parameter display block 430 that displays a scan parameter of imaging currently being performed, an image display block 420 that displays an image obtained by the imaging currently being performed, and a GUI block 440 for the user to give an instruction to start or stop the imaging.

In this example, for example, a plurality of (here, eight) slice images obtained by TW2 imaging are displayed in the image display block 420, and among the eight slice images, four slice images on the upper side are images that have been subjected to the body movement correction, that is, images after correction of slices in which the body movement has occurred during the collection of measurement data. The four slice images on the lower side are slice images in which there is no body movement that affects image reconstruction during the collection of measurement data and that have not been subjected to body movement correction.

In the eight images, it is not possible to check whether or not the body movement correction is performed from the images. However, in the four images that have been subj ected to the body movement correction, the ratio of the measurement data (correction target data) to be subjected to the body movement correction as the body movement correction information, for example, the ratio of the measurement data subjected to the body movement correction by sequential calculation reconstruction through deletion to the entire k-space data is displayed as "%" in the margins. The user can confirm that the image has been subjected to the body movement correction from the presence or absence of the display, and can also estimate the degree of the effect of the body movement from the displayed numerical value of "%", that is, the reliability of the reconstructed image. That is, even in a case where the amount of the body movement correction data is large even in the image subjected to the body movement correction, the SN of the image after the body movement correction is lower than the SN of the image that is acquired without being affected by the body movement, and the image quality is likely to be deteriorated, so that the reliability in the diagnosis is likely to be lowered. Such information can be estimated from the ratio of the correction target data.

In addition, although not shown in Fig. 4, for example, in an image in which the correction target data includes data of a low frequency range of the k-space and the ratio in the low frequency range exceeds a predetermined value, it is also possible to add information related to the position of the correction target data in the k-space, such as highlighting the ratio "%" in red. As a result, it is possible to provide detailed information in a case where the user further determines the image quality and subsequent processing (for example, re-measurement, change of reconstruction condition, and the like). The user setting for providing information related to the body movement correction and subsequent processing will be described in the embodiment described below.

A predetermined ratio may be set in advance for each of the ratio of the correction target data to the k-space data and the ratio of the correction target data to the low frequency range of the k-space, or the user may appropriately set the ratio in consideration of the purpose of imaging, desired image quality, and the like. The ratio set in advance is determined in consideration of allowable blurring of the image and the like, and is not limited. For example, in a case where the measurement data is deleted by sequential calculation reconstruction or the like, the ratio with respect to the k-space data is set to 30% or less, 20% or less, or the like. **In** addition, the ratio occupied by the low frequency region of the k-space is set to 10% or less. The GUI set by the user will be described in the following embodiment.

According to the present embodiment, the slice image subjected to the body movement correction reconstruction is displayed such that the slice image can be identified as the image subjected to the body movement correction, and the slice image of the adjacent slice image that is not subjected to the body movement correction is displayed as the reference image. Therefore, the user can compare the slice image subjected to the body movement correction with the slice image not subjected to the body movement correction and determine whether or not the body movement correction is appropriately performed, and can perform image reconstruction with different conditions for the body movement correction as post-processing as necessary.

It should be noted that Fig. 4 shows an example in which a plurality of slice images obtained by imaging are displayed at the same time, but some or all of the slice images subjected to the body movement correction and some of the adjacent slice images that have not been subjected to the body movement correction may be displayed.

In addition, in Fig. 4, the content of the body movement correction, that is, the ratio of the correction target data and the like are displayed for the slice image subjected to the body movement correction, so that the slice image is made to be distinguishable from the slice image that is not subjected to the body movement correction. However, a case where the image is simply displayed to be distinguishable by using a color, a mark, or the like without displaying the content of the body movement correction is also included in the present embodiment.

### Modification Example 1

In Embodiment 1, the image that is not subjected to the body movement correction among the plurality of images acquired in the same sequence as the image that is subjected to the body movement correction is displayed as the reference image to be displayed together with the image that is subjected to the body movement correction. However, in the present embodiment, the image that is subjected to the image reconstruction using the k-space data of the image that is subjected to the body movement correction before the correction is displayed as the reference image.

Therefore, in the present embodiment, the image generation unit 220 performs the image reconstruction without performing the body movement correction to generate the original image without the body movement correction (Fig. 2: S6). Here, in a case where a method of performing correction in an image space on the original image is employed as the method for the body movement correction, the original image is already generated, and thus, the original image is used. In addition, in a case where the image is reconstructed by performing the body movement correction such as the sequential operation reconstruction on the k-space data, the original image is reconstructed separately from the body movement correction reconstruction. The image reconstruction of the original image may be performed up to the display of the image, and is not limited to before and after the body movement correction reconfiguration.

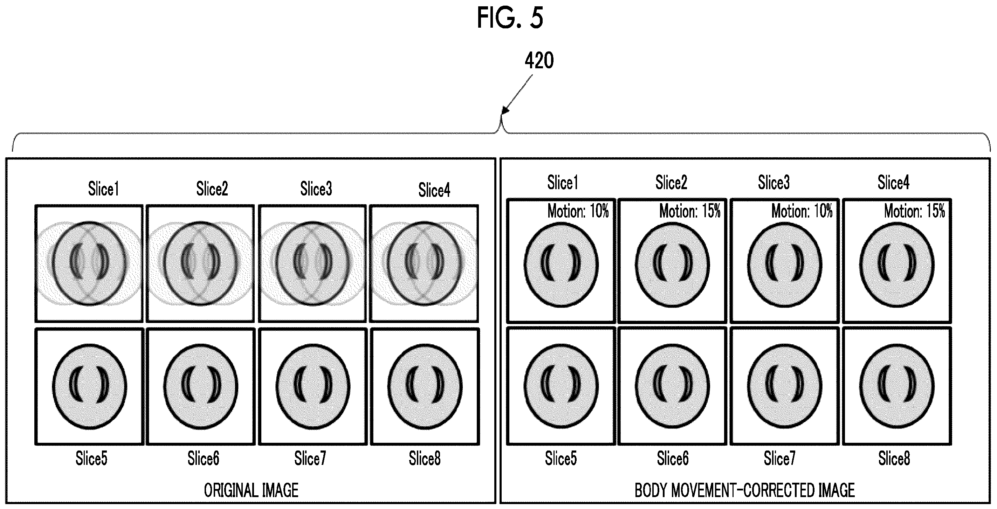

Fig. 5 shows a display example of the image according to the present embodiment. In the example shown in Fig. 5, a set of slice images including the slice image subjected to the body movement correction and a set of slice images consisting of the original images are displayed in parallel in the image display block 420 of Fig. 4. In the original image of the slice with the body movement, an artifact caused by the body movement appears, but the artifact disappears due to the body movement correction. The user can check whether the body movement correction is appropriately performed by comparing the original image and the body movement-corrected image of the same slice, or can check whether or not information that is present in the original image and is lost in the body movement-corrected image is present.

Fig. 5 shows a case where the body movement-corrected image and the original image are displayed for all of the plurality of slice images. However, the original image may be displayed only for the slice image subjected to the body movement correction. The body movement-corrected image and the original image may be displayed for a small number (for example, one) of the images subjected to the body movement correction. In that case, the original image display block may be provided on the default display screen, and the original image may be displayed in the display block, or any display format may be adopted, such as selecting a predetermined slice image by a user operation and making the original image displayable in a pop-up manner. The selection of the image by the user may be provided with a GUI function for user selection in the display of the image itself, or a GUI for user selection may be displayed separately.

### Modification Example 2

In Modification Example 1, the original image of the image subjected to the body movement correction is displayed as the reference image, but a difference image between the image subjected to the body movement correction and the original image may be displayed as the reference image.

In this case, the image generation unit 220 generates a difference image between the body movement-corrected image and the original image together with the generation of the original image. In the same manner as in Embodiment 2, a display method in which a display block of the body movement-corrected image and a display block of the reference image are provided and the difference image is displayed in the display block of the reference image or the difference image is displayed as necessary by the user operation can be adopted. Further, a method may be adopted in which one of the original image and the difference image is displayed by the user selection in the display block of the reference image provided in combination.

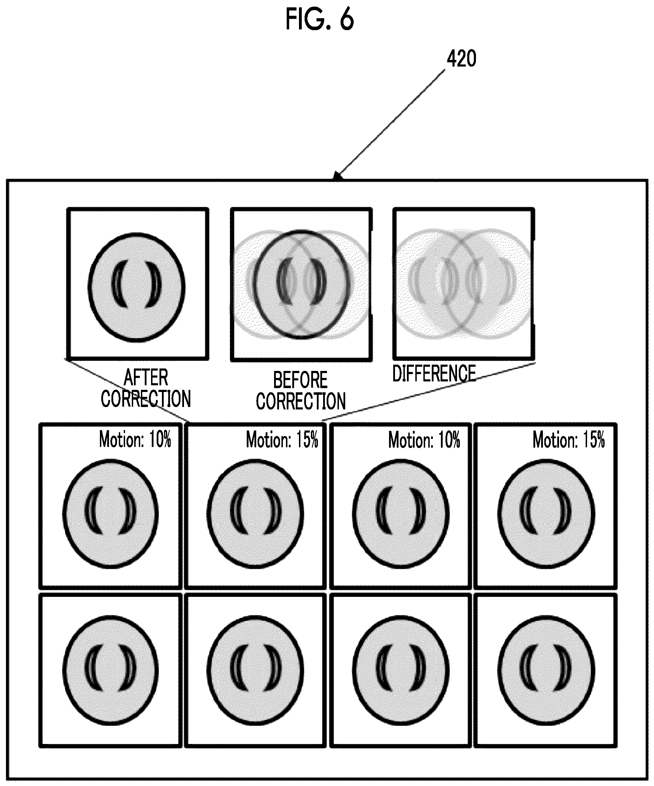

In addition, as shown in Fig. 6, the slice image, the original image, and the difference image may be displayed as one set.

According to Modification Examples 1 and 2, the original image or the difference image is displayed as the reference image together with the image subjected to the body movement correction, so that the user can check the effect of the body movement correction and determine whether or not the body movement correction is appropriate in the same manner as in Embodiment 1. In addition, since the difference image is displayed, the user can more clearly grasp the difference in effect due to the body movement correction.

### Embodiment 2

The present embodiment is characterized in that the display control unit 250 displays information related to the body movement correction together with the image, and displays a GUI for receiving user setting and user selection for the processing after the image display as necessary.

Specifically, the information related to the body movement correction includes a position of the measurement data deleted for the body movement correction in the k-space, a ratio to total measurement data (k-space data), and an image reconstruction method, and further includes information such as an intensity of the body movement correction or a threshold of a magnitude of the body movement in a case where the measurement data for determining the intensity of the body movement correction is deleted. In Embodiment 1, the example is described in which the ratio (%) of the data that is the target of the body movement correction to the k-space data is displayed in the display region of the image subjected to the body movement correction. However, in the present embodiment, the display control unit 250 displays at least one of these pieces of information.

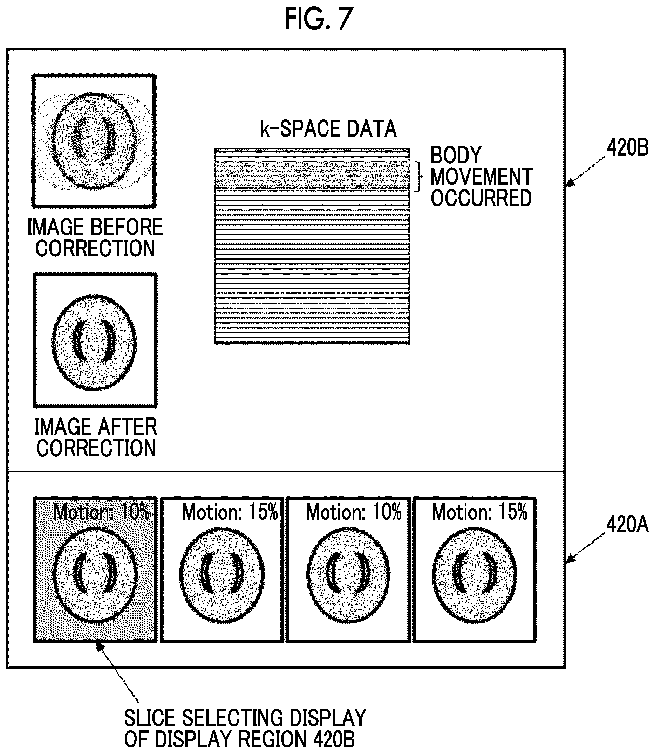

Figs. 7 to 9 show display examples of the image according to the present embodiment.

The display example shown in Fig. 7 is an example in which the position and the proportion of the measurement data deleted by the body movement correction in the k-space are displayed together with the body movement-corrected image. In this display example, the position of the deleted measurement data in the k-space data is presented, and zero replacement of the measurement data at the position is performed. As a result, it is possible to determine whether or not the effect on the image, for example, the effect on the fine structure of the image is large, and it is possible to determine the need for image reconstruction or re-measurement according to the purpose or target of imaging.

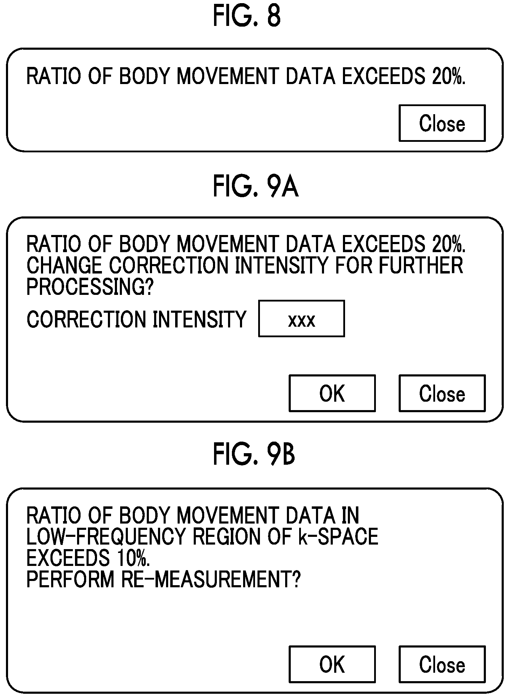

The example shown in Fig. 8 is an example in which the notification information is displayed in a case where the correction target data exceeds a preset threshold in a case where the ratio of the correction target data is shown as shown in Fig. 4. As described in Embodiment 1, the threshold is a ratio set in advance or by the user in consideration of the effect on the image reconstruction. A method for displaying the information to the user is not particularly limited, and may be a pop-up display as illustrated in Fig. 8, or may be displayed as text information in the image display block 420 instead of displaying the image of the corresponding slice.

By presenting such notification information, the user can estimate that the image quality reliability of the image itself is low for the corresponding slice even in a case where the body movement correction is performed, and it is easy to determine subsequent processing.

Fig. 9 is an example of a GUI for receiving user selection in a case where the correction target data exceeds a predetermined threshold. **In** this example, a threshold is set for each of the ratios of the correction target data (the ratio with respect to the entire k-space data and the ratio in the k-space low frequency range), and different GUIs are displayed according to the threshold. In the example of Fig. 9A, for example, in a case where a ratio (here, 20%) at which the correction target data exceeds the allowable range of the blurring of the image is exceeded, a notification that 20% is exceeded is provided, and a GUI for inputting a change in correction intensity is displayed.

The correction intensity is determined by the size of the time window for monitoring the body movement and the range of the magnitude of the body movement. For example, in a case where the time window is widened, the body movement is detected for a long time in a case where the displacement gently returns to the original displacement after the body movement, and the intensity of the correction is increased. In addition, by reducing the threshold of the magnitude in a case of determining the body movement, even a relatively small displacement is processed as the body movement, so that the intensity of the correction is increased. The correction intensity can be classified by a plurality of thresholds obtained by combining the time window of the body movement monitoring and the magnitude of the body movement, and can be applied to, for example, "weak", "medium", "strong", or the like.

In a case where the user resets the correction intensity or the threshold through the GUI of Fig. 9A, the body movement processing unit 230 and the image generation unit 220 set the correction target data with a new correction intensity using the user-set correction intensity received by the display control unit 250, and perform the body movement-corrected image reconstruction.

On the other hand, in a case where the proportion of the low frequency data in the correction target data exceeds, for example, a predetermined proportion, it is difficult to perform the body movement correction by the image processing, and thus it is necessary to perform the re-measurement. However, in some cases, it is not necessary or impossible to perform re-measurement depending on the slice or a request such as an imaging time. The example of Fig. 9B is an example of a GUI displayed in such a case, and notifies that the correction target data exceeds a predetermined ratio (here, 10%) and displays a button for the user to select whether or not to perform the re-measurement.

The GUI shown in Figs. 8, 9A, and 9B can be displayed on the display device (GUI display block) by the display control unit 250 using a template created in advance, and the information input or selected by the user is passed to the image generation unit 220 or the imaging unit 10 via the display control unit 250, and processing according to the user setting or selection is executed.

According to the present embodiment, by checking the condition for the body movement correction together with the body movement-corrected image, it is possible to obtain a guideline for setting a more appropriate condition in a case where the condition is changed and the body movement correction processing is performed thereafter, and it is possible to generate an image in which the body movement correction is optimally performed.

The present embodiment can be used in combination with the above-described embodiment 1 and the modification example thereof. That is, in a case where the body movement-corrected image and the reference image are displayed, it is also possible to display information regarding the body movement correction performed on the body movement-corrected image in association with the body movement-corrected image.

### Embodiment 3

In all of the above-described embodiments, the body movement correction reconstruction is performed to generate the body movement-corrected image in a case where the body movement occurs. However, in some cases, depending on the magnitude or duration of the body movement, the body movement correction may not be sufficient and re-measurement may be required. The present embodiment relates to a display method in a case where re-measurement is performed automatically or in response to a user instruction.

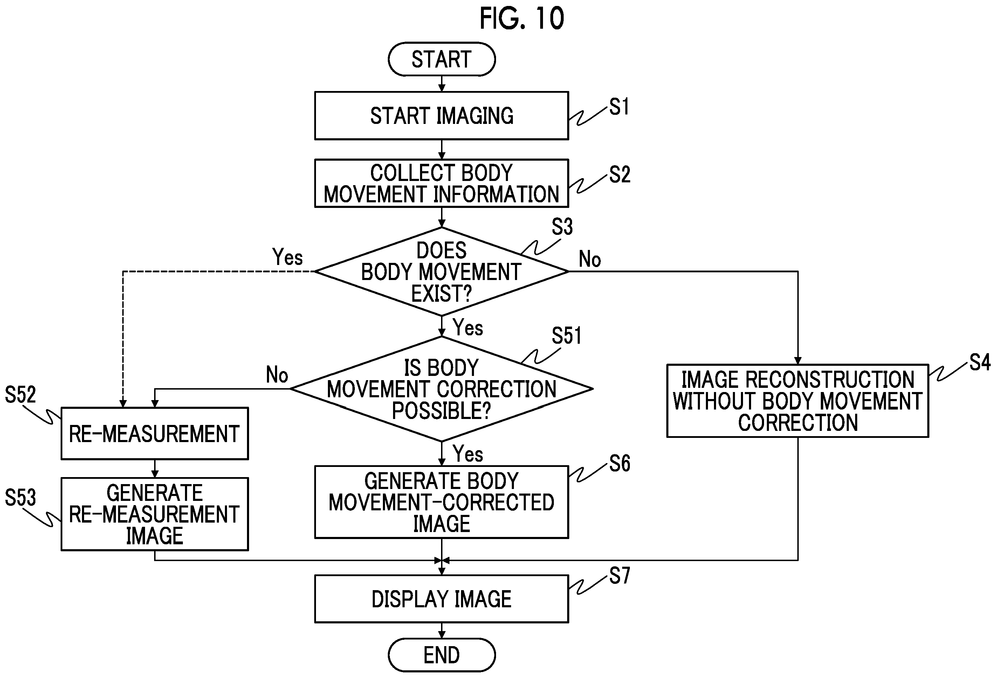

First, Fig. 10 shows a flow of processing in a case where the re-measurement is performed. In Fig. 10, the same processes as those in Fig. 2 are denoted by the same reference numerals, and the duplicate description will be omitted.

As shown in the figure, the imaging unit 10 starts imaging (S1), and the body movement processing unit 230 collects body movement information (S2). As a result of the analysis of the body movement processing unit 230, in a case where it is determined that the body movement has occurred during the imaging (S3), the body movement processing unit 230 specifies measurement data affected by the body movement based on an occurrence time of the body movement, and sets the measurement data as correction target data. Further, the body movement processing unit 230 determines whether or not body movement-corrected image reconstruction is possible using the correction target data (S51). The determination of whether or not the body movement correction is possible can be performed based on the magnitude and the duration of the body movement, and additionally, the determination is performed based on the ratio of the correction target data, that is, the ratio to all the data in the k-space, and the ratio to the low-frequency region in the k-space. Specifically, in a case where any one of the ratio to all the data of the k-space or the ratio to the low-frequency region of the k-space exceeds the threshold, it is determined that the body movement correction is not possible.

In the above description, the re-measurement (S52) is performed after the determination of the occurrence of the body movement (S3) and the determination of whether or not the body movement correction is possible (S51) are performed. However, as indicated by a dotted arrow in Fig. 10, it is also possible to automatically re-measure the data affected by the body movement without going through the determination step (S51) after the determination of the occurrence of the body movement.

In a case where the body movement correction is possible, the processing is the same as the processing in Fig. 2, the body movement-corrected image is generated (S6), and the image is displayed together with the image that has not been subjected to the body movement correction or other reference images (original image or difference image) (S7).

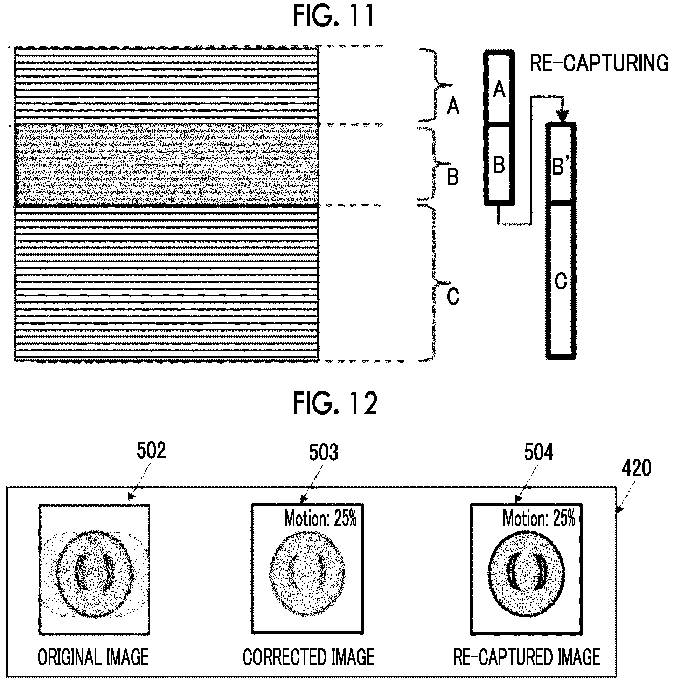

On the other hand, in a case where it is determined that the body movement correction is not possible and the user selects re-measurement, the re-measurement is performed, and the re-measurement of the line where the body movement has occurred on the k-space and the subsequent lines is performed (S52). Fig. 11 shows an example of the re-measurement of the k-space. This example is an example in which body movement occurs in a transition from a high-frequency region to a low-frequency region in a case where the k-space is sequentially measured in an order from high-frequency data on an upper side to low-frequency data and then from the low-frequency data to high-frequency data on a lower side. That is, in the figure, the body movement occurs in a region indicated by B. In this case, since the ratio of the correction target data to the low-frequency region of the k-space exceeds the predetermined threshold in the determination step S51, it is determined that the re-measurement is necessary, and the pulse sequence for imaging starts re-measurement from a region B and then continues up to the measurement of a region C. The data collected before the re-measurement (data being collected) and the data collected after the re-measurement are stored in the memory in the processor 20, and the image generation unit 220 generates a plurality of types of images using these data (S53).

First, the image generation unit 220 generates a re-captured image 504 (image at the right end of Fig. 12) using measurement data of a region A, a region B' after the re-measurement, and the region C in the k-space data shown in Fig. 11. In addition, the image generation unit 220 performs image reconstruction on the original image 502 using measurement data of the region B before the re-measurement instead of the data of the region B after the re-measurement. Further, the measurement data of the region B before the re-measurement may be deleted, and the sequential calculation reconstruction or the like may be performed to perform the image reconstruction on a corrected image 503 using the data of the region A and the region C.

The display control unit 250 displays the plurality of types of images reconstructed by the image generation unit 220 on the display device. Fig. 12 is an example in which three images are displayed in parallel, and similarly to the display example in Fig. 4, the ratio "%" of the correction target data to the k-space data is displayed together with the image.

When compared to the re-captured image 504 in which the image is reconstructed using the data after the re-measurement, the original image 502 has an artifact caused by the effect of the body movement, and the corrected image 503 has a strong blurring of the image due to the zero replacement of a relatively large amount of measurement data. However, depending on the repetition time TR of the pulse sequence or an imaging area that is likely to be affected by respiratory movements, the effect of a deviation in measurement time due to the re-measurement may appear in the re-captured image 504. By displaying the plurality of images in this manner, the user can confirm the effect of improving the image quality from each image, or can determine whether or not correction or re-measurement is appropriate.

According to the present embodiment, in a case where the re-measurement is performed, the original image, the body movement-corrected image, and the like are displayed as the reference images together with the re-captured image, so that the user can easily check the processing performed in the apparatus and the appropriateness thereof.

Although the MRI apparatus and the image display method according to the embodiments of the present invention have been described above, the above-described embodiments can be appropriately combined as long as there is no technical contradiction. Furthermore, the above-described display aspects are merely examples, and it is also possible to change or add a function using a display control technology known to those skilled in the art.

In addition, although the processor 20 incorporated in the MRI apparatus 1 is shown in Fig. 1 as the processor that implements the display method according to the embodiment of the present invention, some or all of the functions implemented by the processor 20 can be implemented by a processor that can exchange data with the MRI apparatus 1 and is independent of the MRI apparatus 1, and a method implemented by such a processor is also included in the present invention.

### Explanation of References

1: MRI apparatus
10: imaging unit
20: processor
30: UI unit
210: imaging control unit
220: image generation unit
230: body movement processing unit
250: display control unit
400: display screen
410: protocol display block
420: image display block
430: scan parameter display block
440: GUI block

## Claims

1. A magnetic resonance imaging apparatus (1) comprising:
an imaging unit (10) that collects a nuclear magnetic resonance signal of a subject;
one or more processors (20) configured to perform image generation by reconstructing an image of the subject using k-space data consisting of the nuclear magnetic resonance signal collected by the imaging unit, body movement processing by analyzing a body movement of the subject during imaging, and display control to display the image generated by the image generation unit on a display device,
wherein the one or more processors perform body movement correction based on an analysis result of the body movement processing to generate an image subjected to the body movement correction, and display, in a case of displaying the generated image subjected to the body movement correction, at least one of a reference image related to the image subjected to the body movement correction or information regarding the positions body movement correction on the display device.

2. The magnetic resonance imaging apparatus according to claim 1,
wherein the image to be displayed on the display device includes a plurality of slice images having different slice, and
the one or more processors (20) use a slice image that is not subjected to the body movement correction among the plurality of slice images as a reference image, and display a slice image subjected to the body movement correction in a distinguishable manner from the reference image on the display device.

3. The magnetic resonance imaging apparatus according to claim 1,
wherein the one or more processors (20) use an original image obtained by performing image reconstruction using the k-space data before correction of the image subjected to the body movement correction as a reference image, and display a slice image subjected to the body movement correction in a distinguishable manner from the reference image on the display device.

4. The magnetic resonance imaging apparatus according to claim 1,
wherein the one or more processors (20) generate a difference image between the image subjected to the body movement correction and an original image obtained by performing image reconstruction using the k-space data before correction of the image subjected to the body movement correction, and
the one or more processors use the difference image as a reference image and displays the difference image on the display device together with the image subjected to the body movement correction.

5. The magnetic resonance imaging apparatus according to claim 1,
wherein the one or more processors (20) display, as the information regarding the body movement correction, a ratio of data that is a target of the body movement correction to the k-space data on the display device together with the image subjected to the body movement correction.

6. The magnetic resonance imaging apparatus according to claim 1,
wherein the information regarding the body movement correction includes notification information indicating that a ratio of data that is a target of the body movement correction exceeds a predetermined ratio, and
the one or more processors display the notification information on the display device together with the display of the image.

7. The magnetic resonance imaging apparatus according to claim 6,
wherein the one or more processors (20) display a GUI for receiving a designation of a user for at least one of the body movement correction or re-measurement, on the display device together with the display of the notification information.

8. The magnetic resonance imaging apparatus according to claim 7,
wherein the one or more processors (20) display a GUI for receiving a selection of a user on at least one of a type of the body movement correction or an intensity of the body movement correction, on the display device.

9. The magnetic resonance imaging apparatus according to claim 1,
wherein the imaging unit performs re-measurement on data that is a target of the body movement correction based on the analysis result of the body movement processing unit,
the one or more processors generate a re-measurement image using data collected before the re-measurement and data collected after the re-measurement, and
display the re-measurement image on the display device.

10. A method for displaying an image acquired by a magnetic resonance imaging apparatus (1) on a display device, in which the image includes an image subjected to correction of a body movement of a subject that has occurred during imaging, the method comprising:
displaying at least one of a reference image related to the image subjected to body movement correction or information regarding the body movement correction.

11. The method for displaying an image according to claim 10,
wherein the reference image is any one of an original image obtained by performing image reconstruction using measurement data before correction of the image subjected to the body movement correction, a difference image between the image subjected to the body movement correction and the original image, or an image that is obtained by the same pulse sequence as the image subjected to the body movement correction and that has a different slice position.

12. The method for displaying an image according to claim 10,
wherein the information regarding the body movement correction includes at least one of a ratio of data that is a target of the body movement correction to k-space data in the image subjected to the body movement correction, a condition of the body movement correction, or a difference from an image that is not subjected to the body movement correction.
